(19) Europäisches Patentamt
European Patent Office
Office européen des brevets

(11) **EP 4 711 795 A1**

(12) **EUROPEAN PATENT APPLICATION**

(43) Date of publication:
**18.03.2026 Bulletin 2026/12**

(21) Application number: **24199907.7**

(22) Date of filing: **12.09.2024**

(51) International Patent Classification (IPC):
**G01R 33/561** (2006.01)    **G01R 33/565** (2006.01)

(52) Cooperative Patent Classification (CPC):
**G01R 33/5617; G01R 33/5659**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Siemens Healthineers AG**
**91301 Forchheim (DE)**

(72) Inventor: **Carinci, Flavio**
**97072 Würzburg (DE)**

(74) Representative: **Siemens Healthineers**
**Patent Attorneys**
**Postfach 22 16 34**
**80506 München (DE)**

(54) **CORRECTING DISTURBING EFFECTS IN SPIN-ECHO IMAGING**

(57)    A method for generating a modified spin echo sequence (MSPES) is described. According to the method, a spin echo sequence (SPES) which includes irradiation of excitation RF pulses (EP) exciting the nuclear spins and irradiation of refocusing RF pulses (RP) inverting the excited nuclear spins, is performed. Further, the irradiation phase ($\theta_{exc}$) of the excitation RF pulses (EP) exciting the nuclear spins is changed according to a non-linear function (NLF) of a k-space line index of the spin echo sequence (SPES). Besides this, a method for carrying out magnetic resonance imaging with a spin echo sequence (SPES) of an examination portion is described. Further, a sequence generating device (52) is described. Also a magnetic resonance imaging system (50) is described.

**FIG 2**

200

SPES, EP, RP — 2.I

EP, RP

$NLF \rightarrow \Theta_{exc} \rightarrow EP$ — 2.II

MSPES — 2.III

$MS \rightarrow ADC$ — 2.IV

**Description**

The invention relates to a method for generating a modified spin echo sequence. Further, the invention concerns a method for carrying out magnetic resonance imaging with a spin echo sequence of an examination portion. Furthermore, the invention refers to a sequence generating device. The invention also relates to a magnetic resonance imaging system with which one of the before-mentioned methods can be carried out.

In magnetic resonance imaging, so-called pulse sequences, also referred to as sequences for short, are used to excite nuclear magnetic moments in body substance, to manipulate the magnetization in a location-dependent manner, and to receive high-frequency signals as measurement signals, which provide information about the type and density, in particular the proton density, of the matter present in an area of investigation. Image contrasts are determined by the proton density or the so-called T1 and T2 relaxation times. The T1 relaxation time characterizes the relaxation of the longitudinal magnetization (in the z direction, which is the direction of the field vector of the basic magnetic field $B_0$) and the T2 relaxation time is determined by the relaxation of the transverse magnetization (usually in the xy plane, which is the plane perpendicular to the direction of the field vector of the basic magnetic field Bo).

A common type of sequence is the so-called spin-echo sequence, by short SE sequence. In a SE sequence, an excitation radio-frequency (by short "RF") pulse (typically with a 90° flip angle) is played out, followed by a refocusing pulse (typically with a 180° flip angle, also named "refocusing pulse" or "refocusing RF pulse"). The 90° flip angle is used to deflect the nuclear spins or magnetic moments from the longitudinal axis (typically the z-axis). These lose their uniform alignment over time, but can be realigned by a refocusing pulse, after which a measurement signal called spin-echo signal is generated..

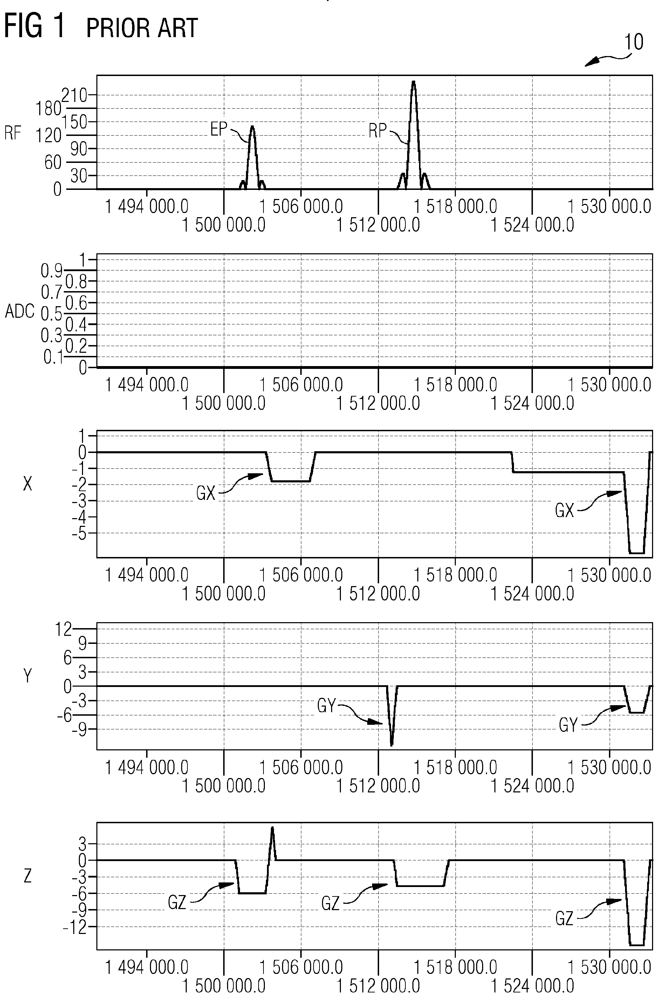

A spin echo sequence is illustrated in FIG 1.

The actual flip angles can deviate significantly from the values mentioned due to inhomogeneities of the RF transmission field B1. The flip angles may also differ from the aforementioned values due to inhomogeneities of the static magnetic field Bo or because the user chooses different values to reduce the SAR (the specific absorption rate).

In the spin echo sequence, the main echo signal is generated by the excitation RF pulse. However, the refocusing pulse can also cause a free induction decay (by short "FID") signal due to the deviation of the refocusing flip angle from the ideal phase angle of 180°. The spin echo signal is encoded by a phase-encoding gradient field applied immediately after the excitation pulse, while the FID signal is not phase encoded and is superimposed on the spin echo. Therefore, zipper-like artifacts parallel to the frequency encoding direction (artifacts caused by the FID signal, hereinafter referred to as FID artifacts) may appear in the image. Free induction decay refers to the RF signal which is generated by the magnetization after it is deflected from its equilibrium position by an RF pulse. This signal is created by inducing a voltage in the detection coil and decays approximately exponentially. The decay time of FID signal is also referred to as T2* because it deviates from the time T2 due to field inhomogeneities of the external magnetic field and local susceptibility variations.

There is therefore a need to reduce the artifacts occurring due to the FID signal.

The FID artifacts can be reduced by using a crusher gradient in at least one spatial direction (phase encoding and/or readout and/or slice direction). This approach is used in most spin echo-based sequences, such as the turbo-spin-echo (TSE) based sequences. However, the crusher gradients also increase the sensitivity of the sequence to blood flow and pulsation, so that, for example, strong pulsation artifacts can be seen on T1-weighted images when contrast agents are used. Typically, no crusher gradients are applied in the SE sequence ("SE" is an abbreviation for "spin-echo"), as can be seen in FIG 1, which makes the sequence much more robust against flow and pulsation artifacts. For this reason, the SE sequence can be preferred to, for example, a TSE sequence for T1 imaging with contrast agent.

The current solution to eliminate FID artifacts in the SE sequence is to use phase cycles through the various k-space lines. In this approach (see for example the EPA patent below, i.e. EP 0 098 479 A2, or Michael N. Hoff et al. "Artifacts in Magnetic Resonance Imaging", Chapter 9, pp. 165-190, Research Gate 2016) the RF phase of either the excitation pulse or that of the refocusing pulse is changed by 180° with each repetition (TR is the short name of repetition time), so that, for example, all odd k-space lines are acquired with an RF refocusing phase of 0° and all even lines with an RF refocusing phase of 180°, or vice versa. This causes a phase shift of the FID signal by 180° in every second k-space line, so that the FID artifact is shifted by FOV/2 in the image space and is no longer visible in the image. The main signal has the same phase for all k-space lines and remains at the original image position.

However, this phase cycle approach is not feasible when using parallel imaging acceleration methods such as GRAPPA, SENSE, SMS or Deep Resolve Boost. In this case, some k-space lines are not acquired, depending on the acceleration factor (AccFactor), and applying the conventional phase cycle (0°-180°) would result in a shift in the FID artifact given by FOV/ 2 /AccFactor. Where AccFactor>2. So the maximum achievable image shift for the FID artifact is FOV/4, which is not enough to remove the artifact from the region of interest.

In order to solve the problem with under-sampled k-spaces, a different phase cycling method has been recently proposed by Fujifilm with patent application US 2022 / 0 187 403 A1.

With this approach, the RF phase of the refocusing pulse is increased quadratically with the k-space line index, while keeping the RF phase of the excitation pulse fixed, similarly to what is done for the RF spoiling in gradient echo based sequences (however only applied to the refocusing pulse). In this way the FID artifact is distributed throughout the whole image and is not localized anymore, reducing the relative signal strength of the FID artifact and its visibility, as compared to the main signal.

Therefore, the task exists to reduce FID artifacts in a spin echo sequence when applying parallel imaging.

This task is solved by a method for generating a modified spin echo sequence according to claim 1, a method for carrying out magnetic resonance imaging with a spin echo sequence of an examination portion according to claim 7, a sequence generating device according to claim 10 and a magnetic resonance imaging system according to claim 11.

According to the method for generating a modified spin echo sequence, a spin echo type pulse sequence, which includes the application of both excitation and refocusing RF pulses, is generated. Further, a modified spin echo sequence is generated by changing the phase of the excitation RF pulse according to a non-linear function of a k-space line index. In contrast to US 2022 / 0 187 403 A1, the phase of the excitation RF pulse is changed and not the phase of the refocusing pulse. Hence, advantageously, an alternative approach has been found to reduce artifacts caused by FID signals.

According to the method for carrying out magnetic resonance imaging with a spin echo sequence of an examination portion, the method for generating a modified spin echo sequence according to the invention is generated. Further, the modified spin echo sequence is applied to the examination portion. Furthermore, magnetic resonance images are reconstructed based on the acquired spin echo signals. Advantageously, images with reduced FID-artefacts are generated compared to prior art methods.

The sequence generating device according to the invention comprises a sequence unit for generating a spin echo sequence which includes excitation RF pulses and refocusing RF pulses. The sequence generating device comprises a modification unit for generating a modified spin echo sequence by changing the irradiation phase of the excitation RF pulses according to a non-linear function of a k-space line of the spin echo sequence. The sequence generating device shares the advantages of the method for generating a modified spin echo sequence.

The magnetic resonance imaging system according to the invention comprises a sequence generating unit according to the invention for generating a spin echo sequence. Further, the magnetic resonance imaging system comprises a scan unit for applying a modified spin echo sequence to an examination portion. Furthermore, the magnetic resonance imaging system comprises a control unit for controlling the scan unit based on the modified spin echo sequence generated by the sequence generating unit. The magnetic resonance imaging device shares the advantages of the method for carrying out magnetic resonance imaging with a spin echo sequence of an examination portion.

Some units or modules of the sequence generating device or the magnetic resonance imaging system mentioned above can be completely or partially realized as software modules running on a processor of a respective computing system, e.g. of a control device of a magnetic resonance imaging system. A realization largely in the form of software modules can have the advantage that applications already installed on an existing computing system can be updated, with relatively little effort, to install and run these units of the present application. The object of the invention is also achieved by a computer program product with a computer program that is directly loadable into the memory of a computing system, and which comprises program units to perform the steps of the inventive method, in particular the steps of the method for generating a modified spin echo sequence according to the invention, when the program is executed by the computing system. In addition to the computer program, such a computer program product can also comprise further parts such as documentation and/or additional components, also hardware components such as a hardware key (dongle etc.) to facilitate access to the software.

A computer readable medium such as a memory stick, a hard-disk or other transportable or permanently-installed carrier can serve to transport and/or to store the executable parts of the computer program product so that these can be read from a processor unit of a computing system. A processor unit can comprise one or more microprocessors or their equivalents.

The dependent claims and the following description each contain particularly advantageous refinements and developments of the invention. In particular, the claims of one claim category can also be developed analogously to the dependent claims of another claim category. In addition, within the scope of the invention, the various features of different exemplary embodiments and claims can also be combined to form new exemplary embodiments.

In a variant of the method for generating a modified spin echo sequence according to the invention, the irradiation phase of the excitation RF pulses is changed according to a quadratic function of the k-space line index. Using a quadratic function of the k-space line index provides an optimal, homogeneous distribution of the FID artifact throughout the image space.

In a preferred variant of the method for generating a modified spin echo sequence according to the invention, the irradiation phase $\theta_{exc}$ of the excitation RF pulses exciting the nuclear spins is changed according to a non-linear non-quadratic function of the k-space line index. Using a non-linear non-quadratic function of the k-space line index provides a homogeneous distribution of the FID artifact throughout the image space.

In a preferred variant of the method for carrying out magnetic resonance imaging with a spin echo sequence of an examination portion, the phase of a receiving electronic unit receiving the spin echo signal is changed by the negative -$\Delta\theta_{exc}$ of the change $\Delta\theta_{exc}$ of the RF phase $\theta_{exc}$ of the excitation pulse. Advantageously, a phase difference between the spin-echo signals in different k-space lines is avoided such that the spin echo signal is not distributed over the field of view and hence artifacts and a blurred image are avoided.

In a preferred version of the method for generating a modified spin echo sequence, additionally to the irradiation phase $\theta_{exc}$ of the excitation RF pulses, the irradiation phase $\theta_{ref}$ of the refocusing RF pulses is changed according to a non-linear function of the k-space line index. Advantageously, the phase change can be distributed to different types of RF pulses. The phase change $\Delta\theta_{exc}$, $\Delta\theta_{ref}$ in both types of RF pulses is carried out such that the phase difference of the phases of the different types of RF pulses varies in a non-linear manner with the k-space line index. The preferred variations of this embodiment are:

- the irradiation phase difference $\theta_{diff}$ between the phase $\theta_{exc}$ of the excitation pulses and the phase $\theta_{ref}$ of the refocusing RF pulses is changed according to a quadratic function of the k-space line index,
- the irradiation phase difference $\theta_{diff}$ between the phases $\theta_{exc}$, $\theta_{ref}$ of the excitation RF pulses and the refocusing RF pulses is changed according to a non-linear non-quadratic function of the k-space line index. The modification based on a non-linear non-quadratic function is to be considered as an alternative solution compared to the modification based on a quadratic function.

Using a non-linear function for modification of the k-space line index provides an optimal, homogeneous distribution of the FID artifact throughout the image space also for modifying the irradiation phase difference $\theta_{diff}$ between the phase $\theta_{exc}$ of the excitation pulses and the phase $\theta_{ref}$ of the refocusing RF pulses.

According to a preferred version of the method for carrying out magnetic resonance imaging with a spin echo sequence of an examination portion, the phase (by short ADC phase) of a receiving electronic unit receiving the spin echo signal is changed by the double of the change $\Delta\theta_{ref}$ of the phase of the refocusing RF pulses, in case the irradiation phase $\theta_{ref}$ of the refocusing RF pulses is changed. Advantageously, a phase difference between the spin-echo signals in different k-space lines is avoided such that the spin echo signal is not distributed over the field of view.

It has to be mentioned that if also the phase $\theta_{exc}$ of the excitation pulse is changed, the above-mentioned change of the ADC phase due to the change $\Delta\theta_{ref}$ of the phase of the refocusing RF pulses is done additionally to the change of the ADC phase, which is required by the phase change $\Delta\theta_{exc}$ of the excitation RF pulse.

In a very preferred variant of the method for generating a modified spin echo sequence, the change $\Delta\theta_{exc}$, $\Delta\theta_{ref}$ of the irradiation phase of the RF pulses is performed according to a function depending on the acceleration factor of the spin echo sequence. Advantageously, due to the consideration of the acceleration, the FID artefact is evenly distributed over the image space, wherein the image quality is further improved.

In a preferred embodiment of the method for generating a modified spin echo sequence, the non-linear function of the k-space line index is defined as follows:

$$\Theta(i) = n * \pi * (\text{AccelFact} - 1) * \left[\frac{i - i_{center}}{\text{AccelFact}}\right]^2 / N,$$

where

n is an integer number
$\Theta$ is the phase of the RF pulse,
AccelFact is the acceleration factor,
i is the index of a k-space line,
$i_{center}$ is the index of the central k-space line, and
N is the total number of k-space lines without acceleration.

Advantageously, the signal due to the FID artefact is evenly distributed over the image space such that the image quality is optimized concerning the suppression of FID artefacts.

In a method for generating a modified spin echo sequence, which is preferably a method as described above, wherein a spin echo type pulse sequence is performed which includes irradiation of excitation RF pulses and irradiation of refocusing RF pulses, the change of the phase difference $\Delta\theta_{diff}$ of the excitation and refocusing RF pulses is applied according to a non-linear non-quadratic function of the k-space line of the spin echo sequence. Advantageously, an alternative method compared to US 2022 / 0 187 403 A1 is developed.

The invention is explained below with reference to the figures enclosed once again. The same components are provided with identical reference numbers in the various figures. The figures are usually not to scale.

FIG 1    illustrates a spin echo sequence according to prior art,

FIG 2      depicts a flow chart illustrating a method according to an embodiment of the invention,

FIG 3      shows a flow chart illustrating a method according to an alternative embodiment of the invention,

FIG 4      shows a flow chart illustrating a method according to a further alternative embodiment of the invention,

FIG 5      a block diagram illustrating a magnetic resonance imaging system according to an embodiment of the invention,

FIG 6      two images for illustrating a FID artefact and the advantageous effect of the method according to the invention.

In FIG 1, a spin echo sequence 10 according to prior art is illustrated. The spin echo sequence 10 uses an excitation RF pulse EP followed by a refocusing pulse RP. Also a readout process of a receiving electronic unit ADC (including an "Analogue to digital converter") is illustrated. The receiving electronic unit ADC receives a high frequency measurement signal (not shown in FIG 1), which is excited by the excitation RF pulse EP and refocused by the refocusing pulse RP. The spin echo signal of the spin echo sequence 10 is encoded by a phase encoding gradient GY applied directly after the excitation pulse EP. Further, also a readout gradient GX in x direction and a slice selection gradient GZ in z direction are played out. The abscissa of the five diagrams shown in FIG 1 illustrates the elapsed time during playing out the spin echo sequence 10 and the ordinate represents the amplitude of the pulses i.e. the RF pulses EP, RP and the gradients GX, GY, GZ. "RF" symbolizes the high frequency of the RF pulses EP, RP. "X", "Y", "Z" represent the direction of the encoding gradient GX, GY, GZ.

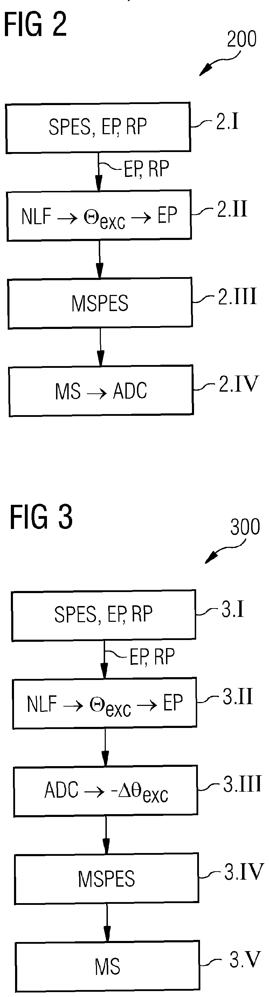

In FIG 2, a flow chart 200 illustrating a method for carrying out magnetic resonance imaging with a spin echo sequence of an examination portion according to an embodiment of the invention is depicted. In step 2.I, a spin echo sequence SPES is planned, which includes irradiation of RF pulses EP exciting the nuclear spins and irradiation of refocusing RF pulses RP inverting the excited nuclear spins.

In step 2.II, an irradiation phase $\theta_{exc}$ of the excitation RF pulses EP exciting the nuclear spins is changed in the spin echo sequence SPES according to a non-linear function NLF of a k-space line index of the spin echo sequence SPES.

In step 2.III, the spin echo sequence MSPES as modified in step 2.II is played out.

In step 2.IV a spin echo MS is received by the ADC.

In FIG 3, a flow chart illustrating a method 300 according to an embodiment of the invention is illustrated.

In step 3.I, a spin echo sequence SPES for carrying out magnetic resonance imaging with a spin echo sequence of an examination portion is planned, which includes irradiation of excitation RF pulses EP exciting the nuclear spins and irradiation of refocusing RF pulses RP inverting the excited nuclear spins.

In step 3.II, an irradiation phase $\theta_{exc}$ of the excitation RF pulses EP exciting the nuclear spins is changed in the spin echo sequence SPES according to a non-linear function NLF of a k-space line index of the spin echo sequence SPES.

In step 3.III, the phase of the ADC is changed to $-\Delta\theta_{exc}$, wherein $\Delta\theta_{exc}$ is the change of the phase of the irradiation phase $\theta_{exc}$ of the excitation pulse EP.

In step 3.IV, the modified spin echo sequence MSPES is played out.

In step 3.V, a spin echo MS is received by the ADC.

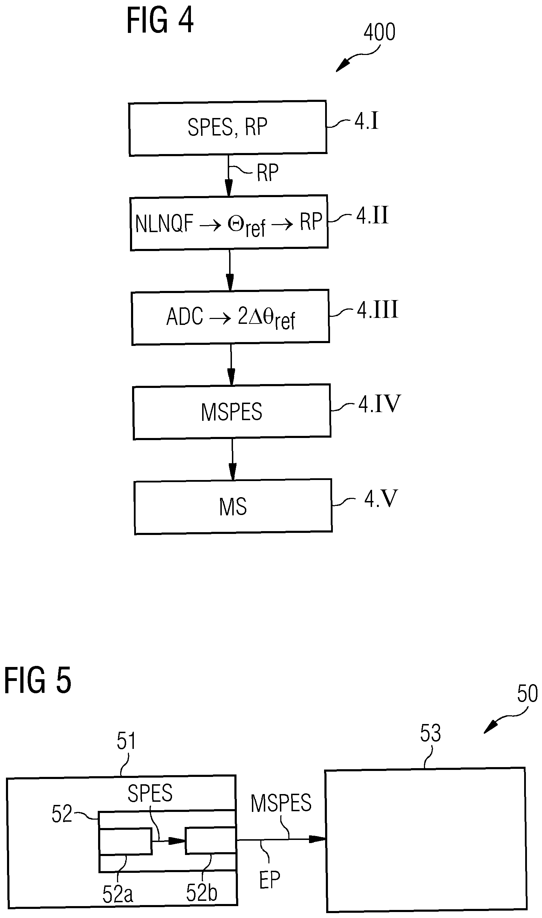

In FIG 4, a flow chart illustrating a method 400 according to an embodiment of the invention is illustrated.

In step 4.I, a spin echo sequence SPES is planned, which includes irradiation of excitation RF pulses EP exciting the nuclear spins and irradiation of refocusing RF pulses RP inverting the excited nuclear spins.

In step 4.II, an irradiation phase $\theta_{ref}$ of the refocusing pulses RP inverting the excited nuclear spins is changed in the spin echo sequence SPES according to a non-linear non-quadratic function NLNQF of a k-space line index of the spin echo sequence SPES.

In step 4.III, the phase of the ADC is changed to $2\Delta\theta_{ref}$, wherein $\Delta\theta_{ref}$ is the change of the irradiation phase $\theta_{ref}$ of the refocusing RF pulses RP.

In step 4.IV, the modified spin echo sequence MSPES is played out.

In step 4.V, a spin echo MS is received by an ADC.

In FIG 5, a block diagram illustrating a magnetic resonance imaging system 50 according to an embodiment of the invention is shown. The magnetic resonance imaging system 50 comprises a control unit 51 for performing a spin echo sequence SPES which includes an irradiation of excitation RF pulses EP exciting nuclear spin and an irradiation of refocusing RF pulses RP inverting excited nuclear spin. The control unit 51 comprises a sequence generating device 52. The sequence generating device 52 comprises a sequence unit 52a for generating a spin echo sequence SPES which includes an irradiation of excitation RF pulses EP exciting the nuclear spins and an irradiation of refocusing RF pulses RP inverting the excited nuclear spins. The sequence generating device 52 also comprises a modification unit 52b for generating a modified spin echo sequence MSPES by changing an irradiation phase $\theta_{exc}$ of the excitation RF pulses EP

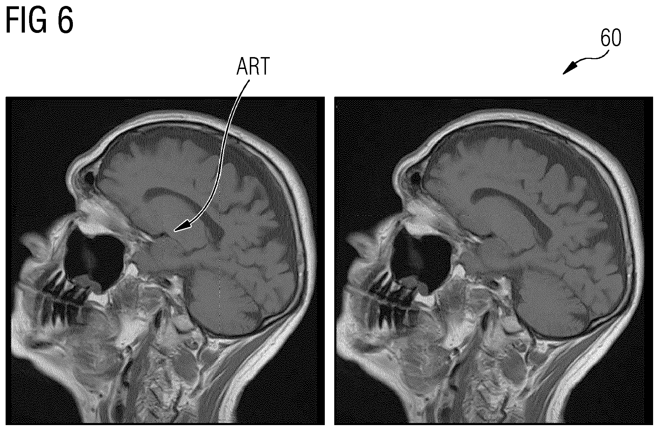

exciting the nuclear spins according to a non-linear function NLF of a k-space line index of the spin echo sequence SPES. The control unit 51 also comprises a receiving electronic unit ADC (not shown in FIG 6) for receiving measurement signals The receiving electronic unit ADC receives high frequency measurement signals, which are excited by the modified spin echo sequence MSPES including a modified excitation pulse EP.

The magnetic resonance imaging system 50 also includes a scan unit 53 for acquiring the measurement signals from an examination portion. The raw data are acquired using the modified spin echo sequence MSPES.

In FIG 6, a schematic view 60 of two images for illustrating a FID artefact ART and the advantageous effect of the method according to the invention is depicted. In the left image, acquired using a prior art imaging method, a vertical aligned artefact ART is depicted in the region of the Limbic system. In the right image, acquired using the method according to an embodiment of the invention, the artefact ART is eliminated.

Finally, it should be pointed out once again that the methods and devices described above are merely preferred exemplary embodiments of the invention and that the invention can be varied by a person skilled in the art without departing from the scope of the invention, insofar as this is determined by the requirements is specified. For the sake of completeness, it should also be noted that the use of the indefinite articles "a" or "an" does not exclude the fact that the characteristics in question can be present multiple times. Likewise, the term "unit" does not exclude the fact that it consists of several components, which may also be spatially distributed. Regardless of the grammatical gender of a particular term, it includes people with male, female or other gender identities.

**Claims**

1. Method for generating a modified spin echo sequence (MSPES), comprising the steps:

    - generating a spin echo sequence (SPES) which includes irradiation of excitation RF pulses (EP) exciting nuclear spins and irradiation of refocusing RF pulses (RP) inverting the excited nuclear spins,
    - generating a modified spin echo sequence (MSPES) by changing an irradiation phase ($\theta_{exc}$) of the excitation RF pulses (EP) exciting the nuclear spins according to a non-linear function (NLF) of a k-space line index of the spin echo sequence (SPES).

2. Method according to claim 1, wherein the irradiation phase ($\theta_{exc}$) of the excitation RF pulses (EP) exciting the nuclear spins is changed according to one of the following types of functions:

    - a quadratic function of the k-space line index of the spin echo sequence (SPES),
    - a non-linear non-quadratic function (NLNQF) of the k-space line index of the spin echo sequence (SPES).

3. Method according to any of the preceding claims, wherein the irradiation phase ($\theta_{ref}$) of the refocusing RF pulses (RP) inverting the excited nuclear spins is changed according to one of the following types of functions:

    - a non-linear function (NLF) of the k-space line index of the spin echo sequence (SPES),
    - a quadratic function of the k-space line index of the spin echo sequence (SPES),
    - a non-linear non-quadratic function (NLNQF) of the k-space line index of the spin echo sequence (SPES).

4. Method according to any of the preceding claims, wherein the change of an irradiation phase of the RF pulses (EP, RP) is performed according to a function depending on the acceleration of the spin echo sequence (SPES).

5. Method according to one of the preceding claims, wherein the non-linear function (NLF) of the k-space line index of the spin echo sequence (SPES) is defined as follows:

$$\Theta(i) = n * \pi * (AccelFact - 1) * \left[\frac{i - i_{center}}{AccelFact}\right]^2 / N,$$

where

    n is an integer number
    $\Theta = \theta_{exc}$ or $\theta_{ref}$ is the phase of the RF pulse,
    AccelFact is the acceleration factor,
    i is the index of a k-space line,

$i_{center}$ is the index of the central k-space line, and
N is the total number of k-space lines without acceleration.

6. Method for generating a modified spin echo sequence (MSPES), particularly according to any of the preceding claims, comprising the steps:

   - generating a spin echo sequence (SPES) which includes irradiation of excitation RF pulses (EP) exciting the nuclear spins and irradiation of refocusing RF pulses (RP) inverting the excited nuclear spins,
   - generating a modified spin echo sequence (MSPES) by changing the phase difference ($\theta_{diff}$) of the phases ($\theta_{exc}$, $\theta_{ref}$) of the excitation RF pulses (EP) exciting the nuclear spins and the refocusing RF pulses (RP) according to a non-linear non-quadratic function (NLNQF) of the k-space line of the spin echo sequence (SPES).

7. Method for carrying out magnetic resonance imaging with a spin echo sequence (SPES) of an examination portion, comprising the steps:

   - performing the method for generating a modified spin echo sequence (MSPES) according to any of the preceding claims,
   - applying the modified spin echo sequence (MSPES) to the examination portion,
   - acquiring spin echo signals from the examination portion,
   - reconstructing magnetic resonance images based on the acquired spin echo signals.

8. Method according to claim 7, wherein the phase of a receiving electronic unit (ADC) receiving the spin echo signal is changed by the negative ($-\Delta\theta_{exc}$) of a change ($\Delta\theta_{exc}$) of the irradiation phase ($\theta_{exc}$) of the excitation RF pulses (EP) exciting the nuclear spins.

9. Method according to claim 7 or 8, wherein, in case the irradiation phase ($\theta_{ref}$) of the refocusing RF pulses (RP) inverting the excited nuclear spins is changed by a phase change value ($\Delta\theta_{ref}$), then the phase of a receiving electronic unit (ADC) receiving the spin echo is changed by the double of the phase change value ($\Delta\theta_{ref}$).

10. Sequence generating device (52), comprising:

    - a sequence unit (52a) for generating a spin echo sequence (SPES) which includes irradiation of RF pulses (EP) exciting the nuclear spins and irradiation of refocusing RF pulses (RP) inverting the excited nuclear spins,
    - a modification unit (52b) for generating a modified spin echo sequence (MSPES) by changing an irradiation phases ($\theta_{exc}$, $\theta_{ref}$) of the RF pulses (EP) exciting the nuclear spins and the RF pulses (RP) inverting the excited nuclear spins according to a non-linear function (NLF) of a k-space line index of the spin echo sequence (SPES).

11. Magnetic resonance imaging system (50), comprising:

    - a sequence generating device (52) according to claim 10, for changing an irradiation phase ($\theta_{exc}$, $\theta_{ref}$) of the excitation RF pulses (EP) exciting the nuclear spins and the refocusing RF pulses (RP) inverting the excited nuclear spins according to a non-linear function (NLF) of the k-space line index of the spin echo sequence (SPES),
    - a control unit (51) for performing a spin echo sequence (SPES) which includes irradiation of excitation RF pulses (EP) exciting the nuclear spins and irradiation of refocusing RF pulses (RP) inverting the excited nuclear spins,
    - a scan unit (53) for acquiring raw data from an examination portion.

12. A computer program product comprising instructions which, when the program is executed by a computer, cause the computer to carry out the steps of the method of any of claims 1 to 9.

13. A computer-readable storage medium comprising instructions which, when executed by a computer, cause the computer to carry out the steps of the method of any of claims 1 to 9.

# FIG 1 PRIOR ART

## FIG 2

200

```
┌─────────────────────┐
│    SPES, EP, RP     │── 2.I
└─────────────────────┘
          │
          ↓  ── EP, RP
┌─────────────────────┐
│  NLF → Θ_exc → EP   │── 2.II
└─────────────────────┘
          │
          ↓
┌─────────────────────┐
│       MSPES         │── 2.III
└─────────────────────┘
          │
          ↓
┌─────────────────────┐
│     MS → ADC        │── 2.IV
└─────────────────────┘
```

## FIG 3

300

```
┌─────────────────────┐
│    SPES, EP, RP     │── 3.I
└─────────────────────┘
          │
          ↓  ── EP, RP
┌─────────────────────┐
│  NLF → Θ_exc → EP   │── 3.II
└─────────────────────┘
          │
          ↓
┌─────────────────────┐
│  ADC → -Δθ_exc      │── 3.III
└─────────────────────┘
          │
          ↓
┌─────────────────────┐
│       MSPES         │── 3.IV
└─────────────────────┘
          │
          ↓
┌─────────────────────┐
│        MS           │── 3.V
└─────────────────────┘
```

## FIG 4

400

| | |
|---|---|
| SPES, RP | 4.I |

↓ RP

| | |
|---|---|
| NLNQF → $\Theta_{ref}$ → RP | 4.II |

↓

| | |
|---|---|
| ADC → $2\Delta\theta_{ref}$ | 4.III |

↓

| | |
|---|---|
| MSPES | 4.IV |

↓

| | |
|---|---|
| MS | 4.V |

## FIG 5

50

53

51

52

SPES

MSPES

52a   52b

EP

FIG 6

# EP 4 711 795 A1

## EUROPEAN SEARCH REPORT

Application Number

EP 24 19 9907

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP S63 11141 A (MITSUBISHI ELECTRIC CORP) 18 January 1988 (1988-01-18) * the whole document * | 1-13 | INV. G01R33/561 G01R33/565 |
| X | US 2022/187403 A1 (ITO KOSUKE [JP] ET AL) 16 June 2022 (2022-06-16) * the whole document * | 1-13 | |
| X | US 4 443 760 A (EDELSTEIN WILLIAM A [US] ET AL) 17 April 1984 (1984-04-17) * the whole document * | 1-13 | |

TECHNICAL FIELDS SEARCHED (IPC)

G01R

The present search report has been drawn up for all claims

| Place of search | Date of completion of the search | Examiner |
|---|---|---|
| Munich | 28 January 2025 | Durst, Markus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 19 9907

This annex lists the patent family members relating to the patent documents cited in the above-mentioned European search report.
The members are as contained in the European Patent Office EDP file on
The European Patent Office is in no way liable for these particulars which are merely given for the purpose of information.

28-01-2025

| Patent document cited in search report | | | Publication date | Patent family member(s) | | Publication date |
|---|---|---|---|---|---|---|
| JP S6311141 | A | | 18-01-1988 | NONE | | |
| US 2022187403 | A1 | | 16-06-2022 | CN | 114624639 A | 14-06-2022 |
| | | | | JP | 7609622 B2 | 07-01-2025 |
| | | | | JP | 2022094087 A | 24-06-2022 |
| | | | | US | 2022187403 A1 | 16-06-2022 |
| US 4443760 | A | | 17-04-1984 | EP | 0098479 A2 | 18-01-1984 |
| | | | | FI | 78987 B | 30-06-1989 |
| | | | | IL | 69141 A | 29-02-1988 |
| | | | | JP | H028664 B2 | 26-02-1990 |
| | | | | JP | S5963551 A | 11-04-1984 |
| | | | | US | 4443760 A | 17-04-1984 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0098479 A2

- US 20220187403 A1, Fujifilm

**Non-patent literature cited in the description**

- **MICHAEL N. HOFF et al.** Artifacts in Magnetic Resonance Imaging. Research Gate, 2016, 165-190